# EUROPÄISCHE PATENTSCHRIFT

(11) **EP 1 436 845 B1**
(45) Veröffentlichungstag und Bekanntmachung des Hinweises auf die Patenterteilung: **05.01.2005**
(21) Anmeldenummer: 02774543.9
(22) Anmeldetag: 30.08.2002
(51) Int. Cl.: H01L 29/78, H01L 29/08, H01L 21/336

(54) **HALBLEITERSTRUKTUR MIT KOMPENSIERTEM WIDERSTAND IM LDD-BEREICH UND VERFAHREN ZU DEREN HERSTELLUNG**
SEMICONDUCTOR STRUCTURE HAVING COMPENSATED RESISTANCE IN THE LDD REGION, AND METHOD FOR PRODUCING THE SAME
STRUCTURE A SEMI-CONDUCTEUR A RESISTANCE COMPENSEE DANS LA ZONE LDD ET SON PROCEDE DE PRODUCTION

(30) Priorität: 17.10.2001 DE 10151202
(43) Veröffentlichungstag der Anmeldung: 14.07.2004
(73) Patentinhaber: Infineon Technologies AG, 81669 München (DE)
(72) Erfinder: TADDIKEN, Hans, 81737 München (DE)
(74) Vertreter: Schoppe, Fritz, Dipl.-Ing.
(86) Internationale Anmeldenummer: PCT/EP2002/009702
(87) Internationale Veröffentlichungsnummer: WO 2003/034499

(56) Entgegenhaltungen:
- CAI J ET AL: "A novel high performance stacked LDD RF LDMOSFET" IEEE ELECTRON DEVICE LETTERS, Bd. 22, Nr. 5, Mai 2001 (2001-05), Seiten 236-238, XP001086941 IEEE, NEW YORK, NY, USA ISSN: 0741-3106
- GEBARA E ET AL: "Output power characteristics of high voltage LDMOS transistors" PROCEEDINGS OF THE 5TH SYMPOSIUM ON GIGAHERTZ ELECTRONICS, GOETEBORG, SWEDEN, 13. - 14. März 2000, Seiten 75-78, XP009012182 in der Anmeldung erwähnt
- DISNEY D R ET AL: "A new 800 V lateral MOSFET with dual conduction paths" PROCEEDINGS OF THE 13TH INTERNATIONAL SYMPOSIUM ON POWER SEMICONDUCTOR DEVICES & ICS (ISPSD '01), OSAKA, JAPAN, 4. - 7. Juni 2001, Seiten 399-402, XP001042542 Inst. Electr. Eng. Japan, Tokyo, JP ISBN: 4-88686-056-7

## Beschreibung

Die vorliegende Erfindung bezieht sich auf eine Halbleiterstruktur mit einem kompensiertem Widerstand in einem LDD-Bereich und auf ein Verfahren zur Herstellung derselben, insbesondere auf eine Halbleiterstruktur mit einem kompensiertem Widerstand in einem LDD-Bereich. Die vorliegende bezieht sich insbesondere auf MOS-Transistoren (MOS = Metal Oxid Semiconductor = Metall Oxid Halbleiter) bei denen zwischen einem Source-Bereich und einem Drain-Bereich ein leicht dotierter Drain-Bereich vorgesehen ist, der als LDD-Bereich bezeichnet wird (LDD = Lightly Doped Drain = leicht dotierter Drain-Bereich). Insbesondere bezieht sich die vorliegende Erfindung auf LDMOS-Transistoren und deren Herstellung (LDMOS = Lateral Diffused MOS = lateral diffundierter MOS).

Bei MOS-Transistoren für Hochleistungsanwendungen oder bei LDMOS-Transistoren für Hochfrequenz-Leistungsanwendungen wird zwischen der Gate-Struktur und dem Drain-Bereich der LDD-Bereich erzeugt, z.B. durch eine Implantation. Bei LDMOS-Transistoren wird vor der Erzeugung des Source-Bereichs auf der Source-Seite des Gates die erforderliche Kanalimplantation eingebracht, die dann in einem nachfolgenden Temperaturschritt unter die Gate-Struktur diffundiert wird.

Vorzugsweise wird bei LDMOS-Transistoren für Hochfrequenz-Leistungsanwendungen auf der dem Drain-Bereich zugewandten Seite der Gate-Struktur ein längerer, n-dotierter LDD-Bereich implantiert. Es wird stets versucht, das Verhalten (Performance) eines solchen LDMOS-Transistors zu verbessern. Eine Verbesserung des Verhaltens wird beispielsweise durch einen Anstieg der Durchbruchsspannung oder durch eine Verbesserung der Hochfrequenz-Eigenschaften erreicht, beispielsweise durch Abschirmung der Gate-Struktur gegenüber dem Drain-Bereich. Um dies zu erreichen, wird im Stand der Technik vorgeschlagen, in dem n-dotierten LDD-Bereich ein flaches, vergrabenes Gebiet mit einer p-Dotierung zu implantieren. Dies wird beispielsweise von H. Söderbärg, u.a. in "Integration of a Novel High-Voltage Giga-Hertz DMOS Transistor into a Standard CMOS Process", IEEE IEDM Washington 1995, Seiten 975-978, von E. Gebara, u.a. in "Output Power Characteristics of High Voltage LDMOS Transistors", GHz 2000 Symp., 5th Symp. on Giga-Hertz-Electronics, Proc Göteborg, S. 13. 14. März 2000, Seiten 78-78 und von D.R.Disney, u.a. in "A new 800V lateral MOSFET with dual conduction paths", 13th Int. Symp. on Power Semiconductor Devices & ICs, Proc. Osaka, JP 4.7. Juin 2001, Seiten 399-402 beschrieben.

Der Nachteil dieser Vorgehensweise besteht darin, dass durch diese Implantation des p-Gebiets der Widerstand des LDD-Bereichs ansteigt, was durch eine entsprechend geeignete Anhebung der Dotierung des LDD-Bereichs sowie durch Einbringen einer zusätzlichen n-Dotierung in den LDD-Bereich im Bereich der p-Gebiets zu kompensieren ist.

Im Stand der Technik wird ein tiefer LDD-Bereich verwendet, der zusätzlich weit unter die Gate-Struktur reicht. Der tiefe LDD-Bereich hat zur Folge, dass die zusätzlich eingebrachte Dotierung in dem p-Gebiet nur eine relativ geringe Gegendotierung zu der n-Dotierung des LDD-Bereichs darstellt, so dass der Widerstand des LDD-Bereichs im Bereich des p-Gebiets nur geringfügig ansteigt. Ferner wird über dem p-Gebiet eine zusätzliche n-Dotierung eingebracht, so dass das p-Gebiet vollständig in dem LDD-Bereich vergraben ist.

Der Nachteil des tiefen LDD-Bereichs besteht darin, dass derselbe weit unter die Gate-Struktur reicht, was zu einer, insbesondere im HF-Bereich unerwünschten Erhöhung der Gate-Drain-Kapazität führt. Jedoch ist dieser tiefe und damit unter die Gate-Struktur reichende LDD-Bereich unverzichtbar, um die Abschirmung der Gate-Struktur bei gleichzeitiger Kompensation des Widerstandsanstiegs aufgrund des p-Gebiets sicherzustellen. Lösungsvorschläge für eine Kompensation des Widerstandsanstiegs bei vergleichsweise flachen LDD-Bereichen, die nicht unter die Gate-Struktur reichen und damit eine niedrige Gate-Drain-Kapazität aufweisen sind im Stand der Technik nicht bekannt.

Außerdem offenbart J. Cai, u.a. in "A novel High Performance Stacked LDD RF LDMOSFET", IEEE Electron Device Letters, Bd. 22, Nr. 5, Mai 2001, Seten 236-238 eine Halbleiterstruktur mit einer dreischichtigen Drainstruktur.

Ausgehend von diesem Stand der Technik liegt der vorliegenden Erfindung die Aufgabe zugrunde, eine verbesserte Halbleiterstruktur und ein Verfahren zur Herstellung derselben zu schaffen, wodurch eine Halbleiterstruktur erhalten wird, die verbesserte Eigenschaften, insbesondere im HF-Bereich, aufweist.

Diese Aufgabe wird durch eine Halbleiterstruktur nach Anspruch 1 sowie einem Verfahren nach Anspruch 7 gelöst.

Die vorliegende Erfindung schafft eine Halbleiterstruktur mit einem Substrat, einem Source-Bereich, der in dem Substrat gebildet ist, und einem Drain-Bereich, der ebenfalls in dem Substrat gebildet ist. Der Drain-Bereich hat eine Dotierung von einem ersten Leitfähigkeitstyp und umfasst einen ersten Drain-Abschnitt mit einer ersten Dotierungskonzentration und einen zweiten Drain-Abschnitt mit einer zweiten Dotierungskonzentration. Die erste Dotierungskonzentration ist höher als die zweite Dotierungskonzentration. Ferner ist in dem zweiten Drain-Abschnitt ein erstes Gebiet gebildet, das eine Dotierung von einem zweiten Leitfähigkeitstyp aufweist, der von dem ersten Leitfähigkeitstyp unterschiedlich ist. Die Halbleiterstruktur umfasst ferner ein zweites Gebiet, das in dem Substrat unter dem zweiten Drain-Abschnitt gebildet ist und eine Dotierung von dem ersten Leitfähigkeitstyp aufweist. Ferner ist zwischen dem Source-Bereich und dem zweiten Drain-Abschnitt ein Kanalbereich in dem Substrat festgelegt.

Die vorliegende Erfindung schafft ferner ein Verfahren zur Herstellung einer Halbleiterstruktur, bei der zunächst eine Gate-Struktur auf einem Substrat erzeugt wird, ein Source-Bereich mit einer Dotierung von einem ersten Leitfähigkeitstyp in dem Substrat erzeugt wird, und ein Drain-Bereich mit einer Dotierung von dem ersten Leitfähigkeitstyp in dem Substrat erzeugt wird. Der Drain-Bereich wird durch Erzeugen eines ersten Drain-Abschnitts mit einer ersten Dotierungskonzentration und eines zweiten Drain-Abschnitts mit einer zweiten Dotierungskonzentration, die niedriger ist als die erste Dotierungskonzentration erzeugt, wobei der zweite Drain-Abschnitt zwischen dem ersten Drain-Abschnitt und der Gate-Struktur gebildet ist. Ferner wird ein erstes Gebiet in dem zweiten Drain-Abschnitt durch Einbringen einer Dotierung von einem zweiten Leitfähigkeitstyp in den zweiten Drain-Abschnitt erzeugt, und ein zweites Gebiet wird unter dem Drain-Abschnitt in dem Substrat durch Einbringen einer Dotierung von dem ersten Leitfähigkeitstyp erzeugt.

Gemäß der vorliegenden Erfindung wird eine Halbleiterstruktur geschaffen, bei der sich der LDD-Bereich im wesentlichen nicht unter die Gate-Struktur erstreckt, so dass eine hohe Gate-Drain-Kapazität vermieden wird.

Dies wird vorzugsweise dadurch erreicht, dass die Erzeugung des LDD-Bereichs, z.B. durch Implantation, erst nach der Gate-Strukturierung erfolgt. Anstelle der anfänglichen Strukturierung der Gate-Struktur kann auch eine entsprechende Maskierung vorgesehen sein, so dass eine Implantation in diesem Fall vor der. Gate-Strukturierung durchgeführt werden kann. Ferner kann auf andere, im Stand der Technik bekannte Maßnahmen zurückgegriffen werden, um sicherzustellen, dass ein LDD-Bereich im wesentlichen nur an die Gate-Struktur angrenzt, nicht jedoch unter die Gate-Struktur reicht.

Die Erzeugung des LDD-Bereichs, z.B. durch Implantation, nach der Gate-Strukturierung führt zu einem flachen LDD-Bereich, so dass das zusätzliche p-Gebiet zur Verbesserung der Eigenschaften des LDMOS-Transistors ebenfalls flach sein muss. Hierdurch steigt der Widerstand des LDD-Bereichs im Bereich des p-Gebiets stark an. Um diesen Anstieg zu kompensieren ist ein zusätzliches n-Gebiet erforderlich, das vorzugsweise mit der gleichen Maske wie das p-Gebiet erzeugt wird. Anders als im Stand der Technik wird das zusätzliche n-Gebiet unter dem LDD-Bereich in dem Substrat, z.B. durch Implantation, erzeugt, so dass der LDD-Bereich in diesen Bereichen nach unten (in Richtung des Substrats) ausgeweitet ist.

Gemäß einem Ausführungsbeispiel bleibt das p-Gebiet derselben floatend, wird also mit keinem Potential verbunden. Gemäß einem anderen Ausführungsbeispiel wird das p-Gebiet mit einem Bezugspotential, z.B. Masse, verbunden, wodurch ein definierter Ladungsträgerabbau erreicht wird.

Der Vorteil der vorliegenden Erfindung besteht darin, dass im Bereich der Gate-Struktur ein flacher LDD-Bereich erzeugt wird, der zudem nicht unter die Gate-Struktur ausgedehnt ist, so dass auch die Gate-Drain-Kapazität gering gehalten wird.

Im Gegensatz zu dem im Stand der Technik bekannten Verfahren wird hier zusätzlich zu dem ursprünglichen LDD-Bereich ein zusätzliches n-Gebiet unter den ursprünglichen LDD-Bereich eingebracht, um den Widerstandsanstieg des LDD-Bereichs im Bereich des p-Gebiets zu kompensieren. Anders als im Stand der Technik stellt die p-Dotierung des p-Gebiets in dem flachen LDD-Bereich eine nicht unerhebliche Gegendotierung dar, die durch die erfindungsgemäße Lösung kompensiert wird. Im Gegensatz zum Stand der Technik wird das zusätzliche n-Gebiet unterhalb des p-Gebiets und unterhalb des LDD-Bereichs, also im Substrat, angeordnet. Hierdurch wird, im Vergleich zum Stand der Technik, ein vergleichsweise flacher LDD-Bereich ermöglicht.

Bevorzugte Weiterbildungen der vorliegenden Anmeldung sind in den Unteransprüchen definiert.

Anhand der beiliegenden Zeichnungen werden nachfolgend bevorzugte Ausführungsbeispiele der vorliegenden Anmeldung näher erläutert. Es zeigen:
Fig. 1 eine Darstellung eines LDMOS-Transistors mit einem doppeltimplantierten LDD-Bereich gemäß der vorliegenden Erfindung;
Fig. 2 einen Graphen, der die Eingangskennlinie des LDMOS-Transistors aus Fig. 1 für verschiedene Implantationen im LDD-Bereich wiedergibt; und
Fig.3 einen Graphen, der die Durchbruchkennlinie des LDMOS-Transistors aus Fig. 1 für unterschiedliche Implantationen im LDD-Bereich wiedergibt.

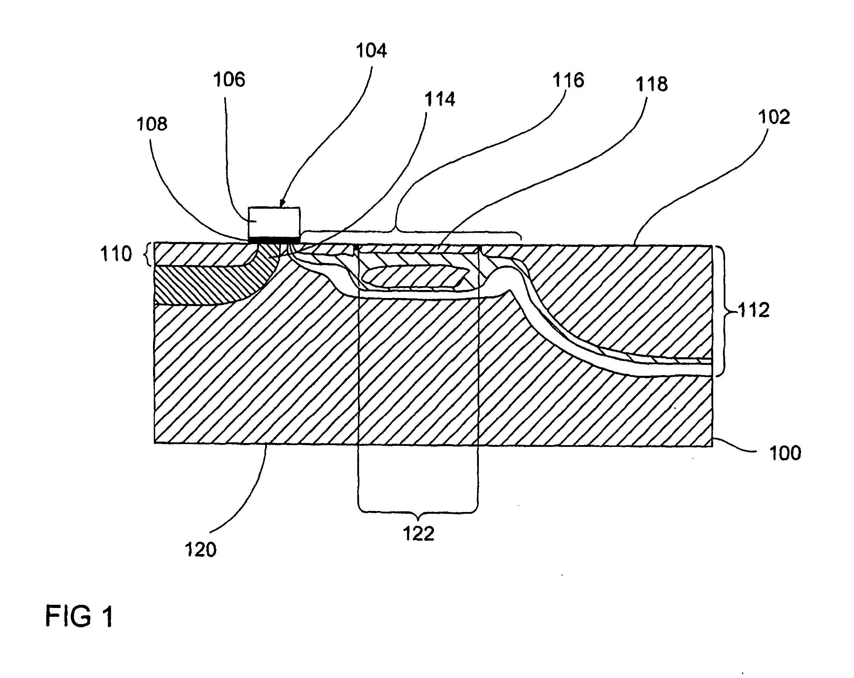

In Fig. 1 ist ein LDMOS-Transistor mit einer p/n-Doppelimplantation in dem LDD-Bereich gemäß der vorliegenden Erfindung dargestellt. Der LDMOS-Transistor ist in einem Substrat 100 gebildet, welches beispielsweise ein p-Substrat ist. In Fig. 1 ist lediglich das Substrat 100 dargestellt, jedoch ist gemäß der vorliegenden Erfindung unter dem Begriff "Substrat" auch eine Struktur zu verstehen, welche eine Substratschicht und eine Epitaxieschicht auf der Substratschicht umfasst.

Das Substrat 100 hat eine p-Dotierung von etwa 3 x 10¹⁵ 1/cm³. Auf einer Oberfläche 102 des Substrats 100 ist eine Gate-Struktur 104 gebildet, die ein Gatepolysilizium 106 und ein Gateoxid 108 umfasst, das zwischen dem Gatepolysilizium 106 und dem Substrat 100 angeordnet ist. In dem Substrat 100 ist ferner ein n⁺-Source-Bereich 110 und ein n⁺-Drain-Bereich 112 gebildet. Unter dem Gateoxid 108 ist ein lateral diffundierter Kanalbereich 114 gebildet, der eine p-Dotierung im Bereich von etwa 2 x 10¹⁷ 1/cm³ aufweist. Der Source-Bereich 110 und der Drain-Bereich haben jeweils n-Dotierung von etwa 2 x 10²⁰ 1/cm³.

Zwischen der Gate-Struktur 104 und dem Drain-Bereich 112 ist ein LDD-Bereich 116, z.B. durch Implantation, gebildet, der eine Dotierungskonzentration aufweist, die niedriger ist als die Dotierungskonzentration des Drain-Bereichs. Bei dem dargestellten Ausführungsbeispiel liegt die Dotierungskonzentration des LDD-Bereichs bei etwa 10¹⁷ 1/cm³.

Zur Verbesserung des Verhaltens des LDMOS-Transistors ist in dem LDD-Bereich 116 ein p-Gebiet 118 gebildet, z.B. durch Implantation, mit einer p-Dotierungdosis von etwa 1 x 10¹² 1/cm².

Um einen Widerstandsanstieg aufgrund des eingebrachten, flachen p-Gebiets 118 in dem LDD-Bereich 116 des LDMOS-Transistors zu verhindern, ist ein weiteres n-Gebiet 120 vorgesehen, das unter dem p-Gebiet 118 und unter dem LDD-Bereich 116 liegt, also in dem Substrat. Die Dotierung des weiteren n-Gebiets 120 erfolgt vorzugsweise mit einer Dosis von etwa 2 x 10¹² 1/cm².

Mit 122 ist in Fig. 1 der Bereich der Doppelimplantation in dem LDMOS-Transistor verdeutlicht.

Bei dem in Fig. 1 dargestellten Ausführungsbeispiel erfolgte die Implantation des LDD-Bereichs 116 vor der Abscheidung des Polymaterials der Gate-Struktur 106. Der LDD-Bereich 116 wird durch Implantation von Arsen (As) bei 80 keV mit einer Dosis von etwa 1,3 x 10¹² 1/cm² erzeugt. Das p-Gebiet 118 wird durch Implantation von Bor (B) bei 18keV mit einer Dosis von etwa 1 x 10¹² 1/cm² erzeugt. Beide Implantationen erfolgen unter einem Winkel von 0° bezüglich der Normalen auf der Substratoberfläche 102.

Das weitere n-Gebiet 120 wird durch eine Implantation von Phosphor (P) bei 300 keV mit einer Dosis von etwa 2 x 10¹² 1/cm² erzeugt. Die Implantation erfolgte unter einem Winkel von 7° bezüglich der Normalen auf der Substratoberfläche 102 und das Substrat (Waferscheibe) wurde während der Implantation viermal gedreht ("quad mode"), um so eine gleichmäßige Erzeugung der Implantation des n-Gebiets 120 sicherzustellen.

Bei der Herstellung wird die Implantation des n-Gebiets 120 unter Verwendung der gleichen Maske durchgeführt, die für die Implantation des p-Gebiets verwendet wurde. Diese führt zu dem definiertem Bereich 122 der in Fig. 1 gezeigt ist.

Bei einem alternativen Ausführungsbeispiel kann der LDD-Bereich 116 durch eine Implantation von Phosphor (P) bei 100 keV mit einer Dosis von etwa 1,2 x 10¹² 1/cm² erzeugt werden.

Obwohl in Fig. 1 das p-Gebiet 118 an der Oberfläche 102 des Substrats freiliegend gezeigt ist, kann das p-Gebiets auch vollständig in den LDD-Bereich 116 eingebettet sein.

Gemäß einem Ausführungsbeispiel der vorliegenden Erfindung ist das p-Gebiet 118 mit keinem Bezugspotential verbunden, ist also "floatend". Bei einem anderen Ausführungsbeispiel kann das p-Gebiet 118 mit einem Bezugspotential, z.B. mit Masse, verbunden sein, wodurch ein definierter Ladungsabbau erreichbar ist.

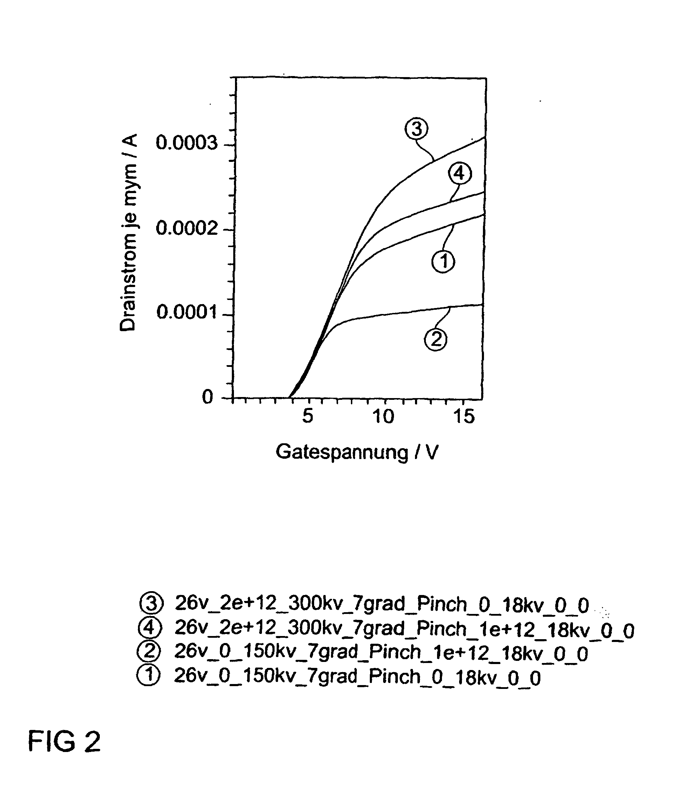

Anhand der Fig. 2 ist die Verbesserung der Eingangskennlinie durch die erfindungsgemäße Doppelimplantation in dem flachen LDD-Bereich 116 dargestellt. In Fig. 2 ist über der Gate-Spannung der Drain-Strom aufgetragen, wobei vier Kurven 1 bis 4 gezeigt sind. Die in Fig. 2 gezeigten Kurven wurden für eine Drain-Spannung von 26 Volt ermittelt und zeigen die Abhängigkeit des Drain-Stroms von der anliegenden Gate-Spannung.

Die Kurve 1 zeigt den Verlauf der Eingangskennlinie nachdem nur der LDD-Bereich 116 implantiert wurde.

Die Kurve 2 zeigt im Verlauf der Eingangskennlinie nach das zusätzlichen p-Gebiet 118 in den LDD-Bereich 116 implantiert wurde. Wie zu erkennen ist, wird hierdurch die Kennlinie abgesenkt, da sich aufgrund des p-Gebiets 118 der Widerstand im LDD-Bereich 116 erhöht, und so der Drain-Strom verglichen mit dem LDD-Bereich ohne zusätzliches p-Gebiet 118 (Kurve 1) entsprechend abnimmt.

Die Kurve 3 zeigt eine Simulation, bei der zusätzlich zu dem LDD-Bereich 116 nur das weitere n-Gebiet 120 unter den LDD-Bereich eingebracht wurde.

Die Kurve 4 gibt den Verlauf der Eingangskennlinie wieder, wie sie für einen LDMOS-Transistor gemäß Fig. 1 erhalten wird, bei dem in dem LDD-Bereich 116 das p-Gebiet 118 implantiert ist und das n-Gebiet 120 unter den LDD-Bereich 116 eingebracht ist. Wie zu erkennen ist, kann hier trotz des zusätzlichen p-Gebiets 118 in dem LDD-Bereich 116, was grundsätzlich zu einer Erhöhung des Widerstands führt (siehe Kurve 2) durch das weitere n-Gebiet erreicht werden, dass der unerwünschte Widerstandsanstieg vermieden wird. Es wird sogar eine Verbesserung der Eingangskennlinie (Kurve 4) verglichen mit dem LDD-Bereich ohne zusätzliche n-Implantation (Kurve 1) erreicht.

Somit ist festzuhalten, dass durch die erfindungsgemäße Vorgehensweise, welche das zusätzliche n-Gebiet 120 unter dem LDD-Bereich lehrt, der Widerstandsanstieg aufgrund des p-Gebiets 118 vermieden werden kann, wodurch der vorteilhafte Effekt des p-Gebiets 118 im LDD-Bereich 116, nämlich die Abschirmung der Gate-Struktur ohne nachteilhafte Einschränkung der Eigenschaften des HF-Transistors erreicht werden kann.

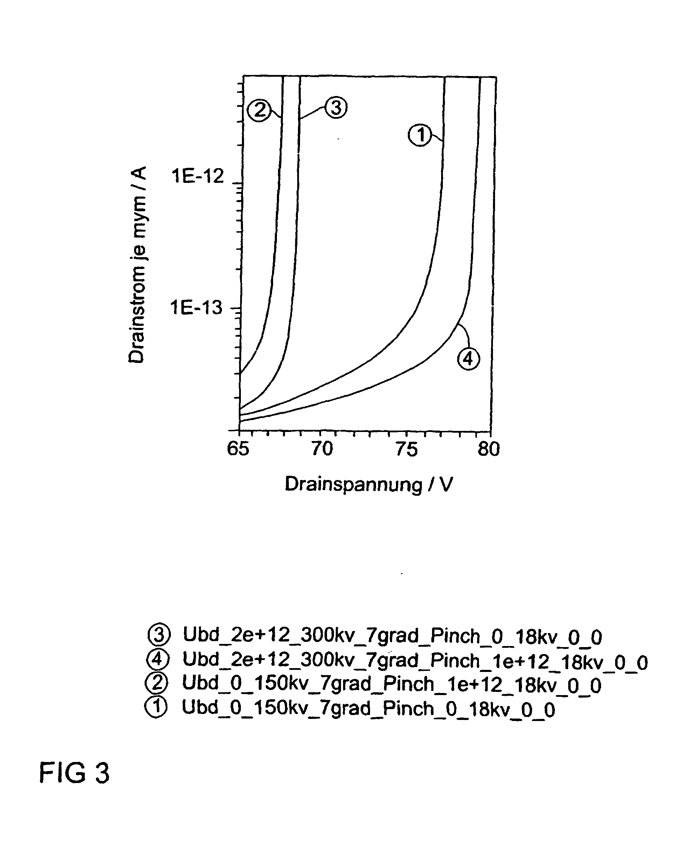

Anhand der Fig. 3 ist eine graphische Darstellung der Durchbruchkennlinie gezeigt, wobei in Fig. 3 über der Drain-Spannung der Drain-Strom aufgetragen ist.

Ebenso wie in Fig. 2 bezeichnet die Kurve 1 den Verlauf der Durchbruchkennlinie bei einem LDMOS-Transistor, der lediglich den LDD-Bereich 116 aufweist.

Die Kurve 2 zeigt den Verlauf der Durchbruchkennlinie eines LDMOS-Transistors mit LDD-Bereich 116 in dem zusätzlich das p-Gebiet 118 implantiert wurde.

Die Kurve 3 zeigt zu Vergleichszwecken den Verlauf der Durchbruchkennlinie für einen LDD-Bereich 116 unter dem das weitere n-Gebiet 120 eingebracht wurde.

Die Kurve 4 zeigt den Verlauf der Durchbruchkennlinie eines LDMOS-Transistors, bei dem in dem LDD-Bereich 116 das p-Gebiet 118 und unter dem LDD-Bereich 116 das weiter n-Gebiet 120 eingebracht wurden.

Wie aus einem Vergleich der Kurven 1 und 2 zu erkennen ist, wird durch die Einbringung des p-Gebiets 118 in den LDD-Bereich 116 die Durchbruchspannung deutlich herabgesetzt, von etwa 76 Volt auf etwa 67 Volt. Diese Abnahme der Durchbruchspannung kann durch das zusätzliche n-Gebiet 120 unterhalb des LDD-Bereichs 116 kompensiert und sogar noch verbessert werden, wie durch die Kurve 4 verdeutlicht wird, bei der sich die Durchbruchspannung auf etwa 79 Volt steigern lässt.

Hinsichtlich der Figuren 2 und 3 ist anzumerken, dass bei diesen von einem LDMOS-Transistor gemäß Fig. 1 ausgegangen wurde, bei dem der LDD-Bereich 116 durch eine Implantation von Arsen (As) bei etwa 80 keV mit einer Dosis von 1,3 x 10¹² 1/cm² erzeugt wurde, wobei die Implantation vor der Abscheidung des Gatepolysiliziums 116 erfolgt. Das p-Gebiet 118 wurde durch eine Implantation von Bor (B) bei etwa 18 keV mit einer Dosis von etwa 10¹² 1/cm² erzeugt. Das weitere n-Gebiet wurde durch eine Implantation von Phosphor (P) bei etwa 300 keV mit einer Dosis von etwa 2 x 10¹² 1/cm² erzeugt. Die Implantation erfolgt in einem Winkel von etwa 7° bezüglich der Normalen der auf der Oberfläche 102, wobei die Scheibe vierfach gedreht wurde, entsprechend des sogenannten "quad mode".

Obwohl die obige Beschreibung des bevorzugten Ausführungsbeispiels der vorliegenden Erfindung anhand eines LDMOS-Transistors mit LDD-Bereich erfolgte, wird darauf hingewiesen, dass das erfindungsgemäße Verfahren auch für MOS-Transistoren Anwendung findet, welche einen LDD-Bereich aufweisen.

Die vorliegende Erfindung ist nicht auf die oben beschriebenen Materialien beschränkt. Anstelle eines p-Substrats 100, eines p-Gebiets 118, eines n-Source-Bereichs 110, eines n-Drain-Bereichs 112, eines n-LDD-Bereichs 116 und eines weiteren n-Gebiets 120, können selbstverständlich auch die komplementären Materialien verwendet werden, also ein n-Substrats 100, ein n-Gebiets 118, eines p-Source-Bereichs 110, eines p-Drain-Bereichs 112, eines p-LDD-Bereichs 116 und eines weiteren p-Gebiets 120.

Ferner ist die Erfindung nicht auf die Implantation der genannten Materialien zur Erzeugung der jeweiligen Bereiche in dem Substrat beschränkt. Andere bekannte Techniken können ebenso verwendet werden.

### Bezugszeichenliste

- 100: Substrat
- 102: Oberfläche des Substrats 100
- 104: Gate-Struktur
- 106: Gatepolysilizium
- 108: Gateoxid
- 110: n⁺-Source-Bereich
- 112: n⁺-Drain-Bereich
- 114: Kanal
- 116: LDD-Bereich
- 118: p-Gebiet
- 120: n-Gebiet
- 122: Bereich der Doppelimplantation

## Patentansprüche

1. Halbleiterstruktur, mit
einem Substrat (100);
einem Source-Bereich (110), der in dem Substrat (100) gebildet ist;
einem Drain-Bereich, der in dem Substrat (100) gebildet ist und eine Dotierung von einem ersten Leitfähigkeitstyp aufweist, wobei der Drain-Bereich einen ersten Drain-Abschnitt (112) mit einer ersten Dotierungskonzentration und einen zweiten Drain-Abschnitt (116) mit einer zweiten Dotierungskonzentration aufweist, wobei die erste Dotierungskonzentration höher ist als die zweite Dotierungskonzentration, wobei in dem zweiten Drain-Abschnitt (116) ein erstes Gebiet (118) gebildet ist, das eine Dotierung von einem zweiten Leitfähigkeitstyp aufweist, der unterschiedlich zu dem ersten Leitfähigkeitstyp ist;
einem zweiten Gebiet (120), das in dem Substrat (100) unter dem zweiten Drain-Abschnitt (116) gebildet ist und eine Dotierung von dem ersten Leitfähigkeitstyp aufweist; und
einem Kanalbereich (114) in dem Substrat (100) zwischen dem Source-Bereich (110) und dem zweiten Drain-Abschnitt (116).

2. Halbleiterstruktur nach Anspruch 1, bei der das zweite Gebiet (120) in dem Substrat (100) derart gebildet ist, dass dasselbe dem ersten Gebiet (118) in dem zweiten Drain-Abschnitt (116) im wesentlichen gegenüberliegt.

3. Halbleiterstruktur nach Anspruch 1 oder 2, bei der die Dotierungskonzentration des zweiten Gebiets (120) höher ist als die Dotierungskonzentration des zweiten Drain-Abschnitts (116).

4. Halbleiterstruktur nach einem der Ansprüche 1 bis 3, bei der das erste Gebiet (118) in dem zweiten Drain-Abschnitt (116) eingebettet ist.

5. Halbleiterstruktur nach einem der Ansprüche 1 bis 3, bei der das erste Gebiet (118) in dem zweiten Drain-Abschnitt (116) derart gebildet ist, dass das erste Gebiet (118) an einer Oberfläche (102) des Substrats (100) freiliegt.

6. Halbleiterstruktur nach einem der Ansprüche 1 bis 5, bei der das erste Gebiet (118) floatend ist oder mit einem Bezugspotential verbunden ist.

7. Verfahren zur Herstellung einer Halbleiterstruktur, mit folgenden Schritten:
(a) Erzeugen einer Gate-Struktur (104) auf einem Substrat (100);
(b) Erzeugen eines Source-Bereichs (110) mit einer Dotierung von einem ersten Leitfähigkeitstyp in dem Substrat (110);
(c) Erzeugen eines Drain-Bereichs mit einer Dotierung von dem ersten Leitfähigkeitstyp in dem Substrat (100) durch Erzeugen eines ersten Drain-Abschnitts (112) mit einer ersten Dotierungskonzentration und eines zweiten Drain-Abschnitts (116) mit einer zweiten Dotierungskonzentration, die niedriger ist als die erste Dotierungskonzentration, wobei der zweite Drain-Abschnitt zwischen dem ersten Drain-Abschnitt (116) und der Gate-Struktur (104) angeordnet ist;
(d) Erzeugen eines ersten Gebiets (118) in dem zweiten Drain-Abschnitt (116) durch Einbringen einer Dotierung von einem zweiten Leitfähigkeitstyp in den zweiten Drain-Abschnitt (116);
(e) Erzeugen eines zweiten Gebiets (120) unter dem zweiten Drain-Abschnitt (116) in dem Substrat (100) durch Einbringen einer Dotierung von dem ersten Leitfähigkeitstyp.

8. Verfahren nach Anspruch 7, bei dem die Schritte (d) und (e) unter Verwendung der gleichen Maske erfolgen.

## Claims

1. A semiconductor structure, comprising
a substrate (100);
a source area (110) formed in the substrate (100);
a drain area formed in the substrate (100) and comprising a doping of a first conductivity type, wherein the drain area comprises a first drain portion (112) having a first doping concentration and a second drain portion (116) having a second doping concentration, wherein the first doping concentration is higher than the second doping concentration, wherein in the second drain portion (116) a first region (118) is formed comprising a doping of a second conductivity type which is different to the first conductivity type;
a second region (120) formed in the substrate (100) below the second drain portion (118) and comprising a doping of the first conductivity type; and
a channel area (114) in the substrate (100) between the source area (110) and the second drain portion (116).

2. The semiconductor structure according to claim 1, wherein the second region (120) in the substrate (100) is formed such that same is substantially opposite to the first region (118) in the second drain portion (116).

3. The semiconductor structure according to claim 1 or 2, wherein the doping concentration of the second region (120) is higher than the doping concentration of the second drain portion (116).

4. The semiconductor structure according to one of claims 1 to 3, wherein the first region (118) is embedded in the second drain portion (116).

5. The semiconductor structure according to one of claims 1 to 3, wherein the first region (118) is formed in the second drain portion (116) such that the first region (118) is exposed at a surface (102) of the substrate (100).

6. The semiconductor structure according to one of claims 1 to 5, wherein the first region (118) is floating or is connected to a reference potential.

7. A method for manufacturing a semiconductor structure, comprising:
(a) forming a gate structure (104) on a substrate (100);
(b) forming a source area (110) having a doping of a first conductivity type in the substrate (100);
(c) forming a drain area having a doping of the first conductivity type in the substrate (100) by forming a first drain portion (112) having a first doping concentration and a second drain portion (116) having a second dopant concentration which is lower than the first doping concentration, wherein the second drain portion is arranged between the first drain portion (116) and the gate structure (104);
(d) forming a first region (118) in the second drain portion (116) by introducing a doping of a second conductivity type into the second drain portion (116);
(e) forming a second region (120) below the second drain portion (116) in the substrate (100) by introducing a doping of the first conductivity type.

8. The method according to claim 7, wherein steps (d) and (e) are performed using the same mask.

## Revendications

1. Structure à semi-conducteur comprenant,
un substrat (100);
une zone (110) de source, qui est formée dans le substrat (100);
une zone de drain, qui est formée dans le substrat (100) et qui a un dopage d'un premier type de conductivité, la zone de drain comportant une première partie (112) de drain ayant une première concentration de dopage et une deuxième partie (116) de drain ayant une deuxième concentration de dopage, la première concentration de dopage étant plus grande que la deuxième concentration de dopage, et il est formé dans la deuxième partie (116) de drain une première région (118), qui a un dopage d'un deuxième type de conductivité, qui est différent du premier type de conductivité;
une deuxième région (120), qui est formée dans le substrat (100) en dessous de la deuxième partie (116) de drain et qui a un dopage du premier type de conductivité; et
une zone (114) de canal dans le substrat (100) entre la zone (110) de source et la deuxième partie (116) de drain.

2. Structure à semi-conducteur suivant la revendication 1, dans laquelle la deuxième région (120) est formée dans le substrat (100), de façon à ce que celle-ci soit sensiblement opposée à la première région (118) de la deuxième partie (116) de drain.

3. Structure à semi-conducteur suivant la revendication 1 ou 2, dans laquelle la concentration de dopage de la deuxième région (120) est plus grande que la concentration de dopage de la deuxième partie (116) de drain.

4. Structure à semi-conducteur suivant l'une des revendications 1 à 3, dans laquelle la première région (118) est incorporée à la deuxième partie (116) de drain.

5. Structure à semi-conducteur suivant l'une des revendications 1 à 3, dans laquelle la première région (118) est formée dans la deuxième partie (116) de drain, de façon à ce que la première région (118) soit à nue sur une surface (102) du substrat (100).

6. Structure à semi-conducteur suivant l'une des revendications 1 à 5, dans laquelle première région (118) est flottante ou est reliée à un potentiel de référence.

7. Procédé de production d'une structure à semi-conducteur comprenant les stades suivants :
(a) production d'une structure (104) de grille sur un substrat (100);
(b) production d'une zone (110) de source ayant un dopage d'un premier type de conductivité dans le substrat (110);
(c) production d'une zone de drain ayant un dopage du premier type de conductivité dans le substrat (100) par production d'une première partie (112) de drain ayant une première concentration de dopage et d'une deuxième partie (116) de drain ayant une deuxième concentration de dopage, qui est plus basse que la première concentration de dopage, la deuxième partie de drain étant disposée entre la première partie (116) de drain et la structure (104) de grille;
(d) production d'une première région (118) dans la deuxième partie (116) de drain par introduction d'un dopage d'un deuxième type de conductivité dans la deuxième partie (116) de drain;
(e) production d'une deuxième région (120) en dessous de la deuxième partie (116) de drain dans le substrat (100) par introduction d'un dopage du premier type de conductivité.

8. Procédé suivant la revendication 7, dans lequel on effectue les stades (d) et (e) en utilisant le même masque.
